# NEUE EUROPÄISCHE PATENTSCHRIFT

(11) **EP 1 623 276 B2**
(45) Veröffentlichungstag und Bekanntmachung des Hinweises auf die Entscheidung über den Einspruch: **26.08.2015**
(45) Hinweis auf die Patenterteilung: 30.08.2006
(21) Anmeldenummer: 04730199.9
(22) Anmeldetag: 29.04.2004
(51) Int. Cl.: G03F 7/20

(54) **MASKENLOSES LITHOGRAPHIESYSTEM**
MASKLESS LITHOGRAPHIC SYSTEM
SYSTEME LITHOGRAPHIQUE SANS MASQUE

(30) Priorität: 29.04.2003 DE 10319154
(43) Veröffentlichungstag der Anmeldung: 08.02.2006
(73) Patentinhaber: Fraunhofer-Gesellschaft zur Förderung der angewandten Forschung e.V., 80686 München (DE)
(72) Erfinder: WALF, Godehard, 14169 Berlin (DE); KUHLOW, Berndt, 13467 Berlin (DE)
(74) Vertreter: Schenk, Markus
(86) Internationale Anmeldenummer: PCT/DE2004/000924
(87) Internationale Veröffentlichungsnummer: WO 2004/097527

(56) Entgegenhaltungen:
- EP-A- 0 903 231
- WO-A-91/10170
- US-A- 5 910 658
- US-A1- 2002 145 113

## Beschreibung

Die Erfindung bezieht sich auf ein maskenloses Lithographiesystem zur direkten, nanoskalierbaren Strukturierung eines auf einem verfahrbaren Halterungstisch angeordneten Substrats in einer hochspannungsbeaufschlagten Vakuumkammer mittels eines von einer Strahlenquelle erzeugten, geladenen Teilchenstrahls mit einem ansteuerbaren digitalen Mustererzeugungssystem, auf das das zu erzeugende Strukturmuster als computerunterstützt erzeugter Musterdatensatz mittels eines Datenübertragungssystems übertragen wird.

Bei der Herstellung von mikrosystemtechnischen Anordnungen und monolithisch integrierten Schaltungen in elektronischer, optoelektrischer, optischer oder anderer Ausführungsart und ihrer Einzelkomponenten mit Nanostrukturen von 100 nm und weniger ist der Teilchenstrahl-Lithographie besondere Bedeutung zuzumessen. Die auf einem Substrat, in der Regel ein Wafer, herzustellende geometrische Struktur wird computerunterstützt in einen Musterdatensatz umgesetzt. Dieser wird entweder zur Herstellung einer unveränderlichen Maske verwendet, die großflächig bestrahlt wird (indirekte Strukturierungstechnik), oder kontinuierlich durch entsprechende Ansteuerung des Teilchenstrahls und des Halterungstisches, auf dem das zu strukturierende Substrat angeordnet ist, abgearbeitet (direkte Strukturierungstechnik). Von Vorteil ist bei der indirekten Strukturierungstechnik die parallele und damit sehr schnelle Umsetzung des Strukturmusters. Als nachteilig sind jedoch die extrem kostenintensive Anfertigung der Masken, die sich nur bei der Massenherstellung von Schaltungslayouts ausgleichen lässt, die Übertragung von Maskenfehlern und die aufwändige Justage bei der Maskenpositionierung anzusehen. Somit wird derzeit die direkte Strukturierungstechnik intensiv weiterentwickelt, da diese den großen Vorteil der Flexibilität bezüglich der erstellbaren geometrischen Strukturmuster aufweist und somit letztendlich kostengünstiger arbeiten kann. Nachteilig ist bei diesem Verfahren jedoch der relativ geringe Durchsatz von Substraten aufgrund des langsamen, seriellen Strukturierungsvorgangs mit dem Teilchenstrahl. Eine größtmögliche Parallelisierung wird daher auch für das direkte Strukturierungsverfahren angestrebt. Bei der Parallelisierung werden unterschiedliche Konzepte verfolgt. Zum einen kann eine Vielzahl von parallelen Teilchenstrahlen erzeugt werden, zum anderen kann eine programmierbare, veränderliche Maske mit ansteuerbaren Einzelelementen (Aperturen) als Mustererzeugungssystem mit einem homogen Teilchenstrahl großen Querschnitts angestrahlt werden. Die bei diesem bevorzugten Konzept zu verarbeitende Datenrate, die die Daten für die Ansteuerung des digitalisierten Strukturmusters mit beispielsweise 600.000 Maskenpunkten, die in der Regel noch mehrfach belichtet werden (Graustufensystem, vergleichbar mit dem Prinzip des Tintenstrahldruckers), und die Ansteuerung des Halterungstisches umfasst, ist jedoch außerordentlich hoch und erreicht ohne Weiteres mehrere Tbit/s, so dass die geeignete Übertragung der Datenrate an das Mustererzeugungssystem im Inneren der Vakuumkammer des Lithographiesystems ein besonderes Problem bei der direkten Strukturierungstechnik darstellt.

Das Lithographiesystem, von der die vorliegende Erfindung als gattungsbildendem Stand der Technik ausgeht, wird in der US 6.379.867 B1 beschrieben. Es wird als "maskenlos" bezeichnet, da keine unveränderliche, starre Maske im herkömmlichen Sinne verwendet wird. Vielmehr ist das Mustererzeugungssystem hier als Pixelpaneel ausgebildet, das eine Vielzahl von ansteuerbaren Einzelelementen, beispielsweise in der Ausbildung von digitalen Spiegeleinrichtungen (Digital Mirror Devices DMD) aufweist, die den Teilchenstrahl durchlassen oder sperren. Das zu erzeugende Muster wird computerunterstützt als Bitmap generiert, in einem Speicher abgelegt und von dort über eine drahtgebundene Signalverbindung an das Mustererzeugungssystem übertragen. Das Datenübertragungssystem ist ausschließlich drahtgebunden aufgebaut. Somit muss zur Erreichung der hohen Datenübertragungsrate eine Vielzahl von drahtgebundenen Datenleitungen in das Innere der Vakuumkammer des Lithographiesystems geführt und dort kontaktiert werden. Es ergeben sich damit Probleme bei deren räumlicher Anordnung und Zuordnung und insbesondere bei der mechanischen Befestigung der Datenleitungen an der Trägerplatte der anzusteuernden Einzelelemente. Weiterhin ist eine Demontage der Drahtverbindungen zu Wartungszwecken in der Vakuumkammer sehr aufwändig. Außerdem können negative Einwirkungen auf die zu übertragenden Daten durch die im Inneren der Vakuumkammer herrschenden Verhältnisse, insbesondere durch die angelegte Hochspannung auftreten.

Die **Aufgabe** für die vorliegende Erfindung ist daher darin zu sehen, ein Lithographiesystem der eingangs genannten Art anzugeben, mit dessen Datenübertragungssystem auch höchste Datenraten zuverlässig in das Innere der Vakuumkammer übertragen werden können und insbesondere keine mechanischen Belastungen des Mustererzeugungssystems durch Kontaktierungen oder Platzprobleme entstehen. Eine einfache Zuordnung der übertragenen Daten zu den anzusteuernden Einzelelementen im Mustererzeugungssystem soll möglich sein. Das erfindungsgemäße Datenübertragungssystem soll unempfindlich im Betrieb sein und eine einfache Montage und Demontage ermöglichen.

Zur **Lösung** dieser Aufgabe ist ein Lithographiesystem nach Anspruch 1 vorgesehen.

Die Erfindung umfasst sowohl die Transformation der zu übertragenden hohen Datenrate in den leistungsfähigen optischen Bereich als auch den leitungsungebundenen Datentransfer in einem Freistrahlverbindungssystem. Mit dem optoelektrischen Datenübertragungssystem bei dem erfindungsgemäßen Lithographiesystem wird das Mustererzeugungssystem von jeder leitungsgebundenen und mechanisch belastenden Kontaktierung nach außen freigehalten und damit wesentlich mechanisch entlastet. Bei der Montage oder Wartung des Lithographiesystems sind somit direkt am Mustererzeugungssystem keine Leitungsverbindungen zur Datenübertragung herzustellen oder zu lösen. Die gesamte Datenübertragung erfolgt bei der Erfindung rein optisch und durch die Integration eines Freistrahlverbindungssystems zumindest direkt vor dem Mustererzeugungssystem auch leitungsungebunden. Das optoelektrische Datenübertragungssystem ist sehr leistungsfähig, so dass auch höchste Datenraten übertragen werden können. Die elektrooptisch gewandelten Daten werden in parallelen Freistrahlen, deren Anzahl über die vorgegebene Wandlungsrate der elektrooptischen Wandler an die zu übertragende Datenrate angepasst ist, direkt zum Mustererzeugungssystem geführt. Bei einer als Beispiel angenommenen Datenrate von 10 Gbit/s pro elektrooptischem Wandler sind für die Übertragung einer Datenrate von 2,56 Tbit/s somit 256 parallele Freistrahlen erforderlich. Diese sind in ihrem Verlauf auf die optoelektrischen Wandler im Mustererzeugungssystem ausgerichtet. Von dort werden die in elektrische Signale gewandelten Daten über eine nachfolgende Signalverarbeitung den Einzelelementen des Mustererzeugungssystems zugeführt. Im gewählten Ausführungsbeispiel detektieren die optoelektrischen Wandler im Mustererzeugungssystem die ankommenden optischen Daten entsprechend mit ihrer Datenrate von 10 Gbit/s. Im Bereich der leitungsungebundenen Freistrahlen wird das Licht als Datenträger in der Vakuumkammer weder von der dort beim Strukturieren herrschenden Hochspannung noch von dem Teilchenstrahl, in der Regel handelt es sich bei den Teilchen um Ionen oder Elektronen, beeinflusst. Das hat den großen Vorteil, dass die Daten optisch direkt auf die optoelektrischen Wandler - auch unter Inkaufnahme von Bahnenkreuzungen mit dem Teilchenstrahl - ohne auftretende Potenzialprobleme eingestrahlt werden können. Platzintensive und aufwändige Leitungsbündelungen und deren mechanische Kontaktierungen entfallen.

Ein optisches Freistrahlverbindungssystem, wie es bei der Erfindung eingesetzt werden kann, ist aus dem Stand der Technik in unterschiedlichen Ausführungsformen allgemein bekannt, in der Regel hier jedoch bei leistungsfähigen Kommunikationseinrichtungen, aber auch zur Datenübertragung an unzugängliche Orte (vgl. beispielsweise EP 0 485 071 A2, hier wird die Datenübertragung an ein hermetisch gekapseltes Gerät unter Wasser beschrieben) oder schwer kontaktierbare Orte (vgl. beispielsweise DE 100 36 237 A1, hier wird ein modularer Maschinenaufbau von einzelnen elektrisch gesteuerten Funktionseinheiten beschrieben, zwischen denen die Daten optisch übertragen werden). Aus dem **Abschlussbericht** zum Verbundprojekt "Optische Signalverarbeitung" (herausgegeben vom Heinrich-Hertz-Institut für Nachrichtentechnik Berlin GmbH, Juli 1994, Kapitel D.6.2.2) ist beispielsweise eine optische 3D-Raumstufe bekannt, die aus kaskadierten elektronischen Schalt- und optischen Freistrahlverbindungsstufen mit Fresnel-Zonenlinsen zur Kollimierung bzw. Fokussierung sowie Volumenhologrammen zur Strahlablenkung aufgebaut ist. Hierbei handelt es sich um ein Freistrahlverbindungsnetzwerk zur Übertragung von Übertragungsraten im Gbit-Bereich, wie es für die optische Signalverarbeitung in einem OFDM-Vermittlungssystem verwendet werden kann. US 2002/145113 A1 offenbart ein Lithographiesystem gemäss dem Oberbegriff des Anspruchs 1.

Das Freistrahlverbindungssystem bei dem Lithographiegerät nach der Erfindung wird im vorliegenden Wortgebrauch prinzipiell als eine Aneinanderreihung von Lichtaustrittsorten in der Funktion von optischen Sendern (z. B. aktive Lichtemitter wie elektrooptische Wandler, z. B. Laserdioden, oder Ausgänge von Lichtwellenleitern), leitungsungebundenen Freistrahlen und Lichteintrittsorten in der Funktion von optischen Empfängern (z. B. aktive Empfangselemente wie optoelektrische Wandler, z. B. Photodioden, oder Eingänge von Lichtwellenleitern) verstanden. Dabei ist es wählbar, wie die Daten an den Lichteintritts- und Lichtaustrittsorten zur Verfügung gestellt bzw. abgegriffen werden. Weiterhin ist die Positionierung des Freistrahlverbindungssystems frei wählbar und damit insbesondere konstruktiven Gegebenheiten und Erfordernissen anpassbar. In der einfachsten Ausführungsform ist das Freistrahlverbindungssystem mit seinen oben aufgezählten Komponenten direkt vor dem Mustererzeugungssystem angeordnet, wobei die optoelektrischen Wandler direkt auf der Aperturplatte angeordnet sind. Die Freistrahlstrecke ist somit sehr kurz. Durch die berührungsfreie Dateneinstrahlung wird das Mustererzeugungssystem mechanisch entlastet, was eine Hauptaufgabe für die vorliegende Erfindung ist. Die Datenübertragung zu den elektrooptischen Wandlern kann bei dieser Ausführungsform leitungsgebunden (elektrisch oder optisch) erfolgen, wobei entsprechende Leitungsdurchführungen in der Wandung der Vakuumkammer vorzusehen sind. Weiterhin können die Lichtaustrittsorte des Freistrahlverbindungssystem im Innern der Vakuumkammer in größerer Entfernung zum Mustererzeugungssystem positioniert sein, wodurch sich eine Verlängerung der Freistrahlstrecke ergibt. Hierbei ist es vorteilhaft, wenn gemäß einer Ausführungsform der Erfindung im Innern der Vakuumkammer optische Umlenkvorrichtungen in den Freistrahlen angeordnet sind. Somit können alle konstruktiven Gegebenheiten im Innern der Vakuumkammer berücksichtigt und die Freistrahlen trotzdem zu den Lichteintrittsorten geführt werden. Bei den Umlenkvorrichtungen, die beispielsweise mitten in der Freistrahlstrecke oder auch direkt von den Lichtaustritts- bzw. -eintrittsorten angeordnet sein können, kann es sich beispielsweise um justierbare Mikrospiegel oder -prismen handeln.

Gemäß einer nächsten Erfindungsausgestaltung kann aber auch vorgesehen sein, dass die Lichtaustrittsorte außerhalb der Vakuumkammer angeordnet sind und die Freistrahlen durch ein lichtdurchlässiges Fenster in der Vakuumkammer in das Innere der Vakuumkammer geleitet werden. Durch diese Maßnahme findet bereits die Datenübertragung in das Innere der Vakuumkammer leitungsungebunden in Form von Freistrahlen statt. Dabei werden die Freistrahlen in einfacher Weise durch ein in die Wandung der Vakuumkammer integriertes Fenster geführt. Bei einer Positionierung der Lichtaustrittsorte außerhalb der Vakuumkammer werden der Platzbedarf und der Montageaufwand des Freistrahlverbindungssystems im Innern der Vakuumkammer verringert. Es ist keine Leitungsdurchführung für die Datenübertragung in das Innere der Vakuumkammer erforderlich und es ergibt sich eine vollständige Entkopplung zu dem Hochvakuum und den Hochspannungsfeldern im Innern der Vakuumkammer. Eine Umlenkung der durch das Fenster in das Innere eintretenden Freistrahlen auf die optoelektrischen Wandler erfolgt wiederum in einfache Weise über optische Umlenkvorrichtungen. Um auch außerhalb der Vakuumkammer Platz einzusparen, kann nach einer anderen Erfindungsfortführung vorgesehen sein, dass die Lichtaustrittsorte direkt von außen am Fenster angeordnet sind. Hierbei ergibt sich noch eine Reihe von weiteren konstruktiven Vereinfachungen, die weiter unten im Text erläutert werden. Desweiteren können die Lichtaustrittsorte vorteilhaft auch die Lichtaustrittsorte rechtwinklig unterhalb des Fensters angeordnet sein und die Freistrahlen über eine zusätzliche optische Umlenkvorrichtung über das Fenster in das Innere der Vakuumkammer geleitet werden. Somit können auch außerhalb der Vakuumkammer optische Umlenkeinrichtungen eingesetzt werden, um die Freistrahlen optimal platzsparend führen zu können. Schließlich kann gemäß einer nächsten Ausgestaltung der Erfindung auch das Fenster in die Vakuumkammer hineingezogen sein. Dadurch wird eine platzsparende Positionierung der Lichtaustrittsorte außerhalb, aber dennoch im Bereich der Vakuumkammer ermöglicht. Weiterhin können vorgegebene optische Abstände leichter eingehalten werden. Näheres hierzu siehe weiter unten im Text und in den Ausführungsbeispielen. Um Störeinflüsse durch Streulicht und andere Effekte bei einer von externen Lichtsaustrittsorten erfolgenden Einstrahlung der Freistrahlen durch das Fenster zu vermeiden, ist es zusätzlich besonders vorteilhaft, wenn das Fenster außerhalb der hindurchtretenden Freistrahlen mit einer Abdeckung gegen Fremdlicht und elektromagnetische Felder abgeschirmt ist. Hierbei kann es sich um einfache mechanische oder auch optische Abdeckungen handeln. Desweiteren können die Freistrahlen zu Arrays gebündelt werden, die örtlich genau begrenzt sind und deren Umfeld leichter abdeckbar ist.

Bei Verwendung geeigneter Lichtquellen können die erzeugten Freistrahlen ohne weitere optische Maßnahmen insbesondere über kurze Strecken im cm-Bereich geführt werden. Vorteilhafter ist es aber auch bereits hier, wenn nach einer weiteren Ausgestaltung des Lithographiegerätes nach der Erfindung kollimierende und fokussierende Mikrolinsen an den Lichtaus- und/oder - eintrittsorten angeordnet sind. Dadurch wird eine Bündelung und genaue Ausrichtung der Freistrahlen ermöglicht. An welchen Stellen Mikrolinsen in den Freistrahlen angeordnet werden, hängt im Einzelnen von der Güte der einzelnen verwendeten Bauelemente ab. Weiterhin werden Leistungsverluste durch große Streuwinkel vermieden und winklige Ausrichtungen der Freistrahlen von den Lichtaustrittsorten und zu den Lichteintrittsorten ermöglicht. Die Mikrolinsen können beispielsweise als Grin- oder Fresnel-zonenlinsen ausgebildet sein. Aufgrund ihrer optischen Eigenschaften können sie aber nur bei relativ kleinen Freistrahlstrecken verwendet werden. Bereits weiter oben wurden die vorteilhafte und platzsparende Anordnung der Lichtaustrittsorte in einem Array erwähnt. Gleiches gilt auch für eine Anordnung der Lichteintrittsorte in einem gemeinsamen Array. Bei diesen Ausführungsformen der Erfindung kann das Array eindimensional als Zeile oder Spalte oder in kompakter Ausführung zweidimensional mit Zeilen und Spalten von entsprechenden Lichtein- bzw. -austrittsorten ausgebildet sein. Bei einer Array-Anordnung kann dann gemäß einer nächsten Erfindungsfortführung vorteilhaft vorgesehen sein, dass das Array der Lichtaustrittsorte über eine Abbildungsoptik auf das Array der Lichteintrittsorte abgebildet wird. Dadurch können auch größere Freistrahlstrecken von 10 cm bis in den Meterbereich realisiert werden. Bei einem gewählten Abbildungsverhältnis von 1:1 muss beim Einsatz einer einfachen Abbildungslinse als Abbildungsoptik diese symmetrisch zwischen den Lichtaustritts- bzw- eintrittsorten angeordnet sein (Gegenstandsweite gleich Abbildungsweite). Um hier nicht zu große Abstände zu erhalten, kann - wie weiter oben bereits beschrieben - beispielsweise das Fenster in die Vakuumkammer hineingezogen werden. Mit der Wahl anderer Abbildungsverhältnisse bzw. bei Einsatz komplexerer Linsensysteme als Abbildungsoptik können entsprechend unsymmetrische Anordnungen der Abbildungsoptik oder Größenunterschiede in den Arrayabmessungen berücksichtigt werden. Bei der Verwendung einer Abbildungslinse müssen die Lichteintrittsorte in der Vakuumkammer eine an der vertikalen und/oder horizontalen Mittelachse (je nach Ausführungsform der Abbildungslinse) gespiegelte Anordnung zu den Lichtaustrittsorten aufweisen.

Weiter oben wurde bereits ausgeführt, dass den Lichtaustrittsorten im Freistrahlverbindungssystem die Aufgabe der Lichtaussendung und den Lichteintrittsorten die Aufgabe des Lichtempfangs zukommt. Dabei können die Orte konstruktiv unterschiedlich und insbesondere passiv oder aktiv realisiert werden. Gemäß einer nächsten Erfindungsfortführung können die Lichteintrittsorte und/oder Lichtaustrittsorte von den Enden von Lichtwellenleitern gebildet werden. Somit können bei dieser passiven Ausgestaltung die Daten bereits optisch gewandelt insbesondere zu den Lichtaustrittsorten über Lichtwellenleiter geleitet werden. Weiterhin können auch die Lichteintrittsorte über Lichtwellenleiter mit den optoelektrischen Wandlern verbunden sein. Dabei können die Lichtwellenleiter als bündelbare Lichtfasern, beispielsweise verlustarme und störunanfällige Glasfasern, oder auch als monolithisch integrierte Wellenleiter ausgebildet sein. Weiterhin können die Enden der Lichtwellenleiter bei deren Ausbildung als Lichtfasern in einem Faserarraystecker zusammengefasst sein. Die Verwendung von Faserarraysteckern ist besonders montagefreundlich und ermöglicht in einfacher Weise Wartungsarbeiten. Außerdem wird die Fehleranfälligkeit reduziert, da die einzelnen Lichtwellenleiter in den Faserarraysteckern fest angeordnet sind und die Faserarraystecker für korrekt ausgerichtete und zugeordnete Verbindungen sorgen. Bei einer Verwendung von 256 parallelen Lichtwellenleitern können beispielsweise 4 Leitungsbündel mit je 64 Lichtwellenleitern gebildet werden.

Jedes Bündel endet dann in einem "64-poligen" Faserarraystecker. Derartige Faserarraystecker ("Ferrule") sind allgemein bekannt (vgl. bspw. **Internetseite** www.xanoptix.com/ferrule.htm, Stand 14.03.2003) und können kommerziell bezogen werden.

Bei einer aktiven Ausgestaltung der Lichtaustrittsorte ist nach einer nächsten Fortführung der Erfindung vorteilhaft vorgesehen, dass die elektrooptischen Wandler als Lichtaustrittsorte in Form von Sendelasern ausgebildet sind. Somit erfolgt die elektrooptische Wandlung der Musterdaten erst direkt am Lichtaustrittsort. Eine leitungsgebundene Zuleitung zu den Sendelasern ist hier unproblematisch, insbesondere, wenn sich diese außerhalb der Vakuumkammer befindet. Aktive Lichteintrittsorte können dadurch realisiert werden, dass entsprechend einer weitern Erfindungsausbildung die optoelektrischen Wandler als Lichteintrittsorte in Form von Photodioden ausgebildet sind. Die Daten werden direkt in den Lichteintrittsorten optoelektrisch gewandelt. Bei einer Ausführung mit aktiven Sendeelementen (z.B. Sendelasern) und aktiven Empfangselementen (z.B. Photodioden) werden somit keine Lichtwellenleiter benötigt, wodurch sich eine besonders kompakte Ausführungsform ergibt. Andere aktive Bauelemente sind ebenfalls einsetzbar. Die optoelektrischen Wandler in Form von Photodioden haben beispielsweise einen Platzbedarf von weniger als 50 µm. Bei einem Abstand zwischen den einzelnen Photodioden in einem Bereich von 250 µm bis 500 µm ergibt sich damit zur Übertragung einer Summendatenrate von 2,56 Tb/s mittels 256 paralleler Lichtwellenleiter und damit 256 in einer Reihe angeordneter Photodioden, die jede zur Ansteuerung einer Gruppe von Einzelelementen (Aperturen) genutzt wird, ein Platzbedarf für das Diodenarray in der einen Richtung zwischen 64 mm und 128 mm benötigt. Ein solches streifenförmiges Diodenarray kann bei einem bekannten Lithographiesystem auf der sogenannten "Blanking Plate", die programmierbare Chips mit den einzelnen Aperturen trägt, angeordnet sein. Ein derartiges programmierbares Apertursystem ist beispielsweise aus der **Zusammenfassung** zu der Veröffentlichung "Programmable aperture plate for maskless high-throughput nanolithography" von I.L. Berry et al. (Journal of Vacuum Science and Technology B, 1997, Vol. 15, No. 6, pp. 2382-2386) bekannt. Der besondere Vorteil des Lithographiesystems nach der Erfindung liegt jedoch in der Überlagerungsmöglichkeit zwischen Lichtstrahlen und Teilchenbahnen in der Vakuumkammer und damit in der Möglichkeit der freien Anordnungswahl und Zugänglichkeit der optoelektrischen Wandler. Damit können besonders platzsparende Anordnungen realisiert werden. Weiterhin ergeben sich bedeutende Vorteile bei der Geschwindigkeit der Datenübertragung auf der Blanking Plate, da kürzere Wege erreicht werden können. Die optoelektrischen Wandler des erfindungsgemäßen Lithographiesystem sind räumlich direkt im digitalen Mustererzeugungssystem angeordnet. Die Zugänglichkeit zu den Wandlern über die freie Raumstrecke in der Vakuumkammer ist dabei immer gewährleistet. Aufwändige, anfällige und störende Verdrahtungen, die auch bezüglich der erreichbaren Datengeschwindigkeit kritisch sind, entfallen. Bei der Ausbildung des Mustererzeugungssystems als programmierbares Aperturplattensystem bei der Erfindung können Photodioden auf der Blanking Plate verteilt angeordnet und dort über Multiplexelemente Gruppen von Aperturen zugeordnet werden, wodurch eine bedeutsame Vereinfachung der Anordnung und Platzeinsparung erreicht wird.

Der datentragende, frele Lichtstrahl auf dem jeweiligen optischen Lichtpfad wird in der Regel durch optische Elemente fokussiert und kollimiert und in seiner Strahlrichtung entsprechend ausgerichtet. Bei der Montage, der Wartung oder auch im Betrieb können jedoch Dejustagen durch machanische Tolerenzen und Formveränderungen sowohl bel der Strahlausrichtung als auch am Detektor- bzw. Wandieron auftreten. Hier ist deshalb ein automatisierbares Justagesystem zur Ausrichtung der Freistrahlen auf die Lichteintrittsorte vorgesehen. Dabei kann das Justagesystem bereits direkt auf den Lichtaustrittsort zugreifen und beispleiswelse eine Lagekorrektur der Lichtaustriffsorte bewirken. Nach einer anderen Erfindungsausgestaltung kann such vorgesehen sein, dass das Justagesystem Im Strahlengang des Frelstrahlverbindungssystems angeordnet ist. Somit findet die Korrektur im optischen Bereich durch entsprechende Optiken statt, was konstruktiv relativ einfach zu realisieren ist. Zur Justage werden elektrische oder optische Rücksignale aus der Vakuumkammer genutzt. Es sind deshalb vorteilhaft im Bereich des Mustererzeugungssystems zusätzliche elektrooptische Wandler angeordnet, mittels denen weitere optische Signals in Rückrichtung, insbesondere Kontroll- und Steuersignale, erzeugt und über Fraistrahien auf zusätzliche optoelektrische Wendler geleitet werden, wobei die weiteren optischen Signale als Rücksignale für das automatisierbare Justagesystem einsetzbar sind. Zur Detektion können beispielsweise Vier-Qusdranten-Photodioden verwendet werden, die durch aufgeteilte Quadrantenmessungen eine genaue Strahlausrichtung über entsprechende Justageeinriehtungen z. B. Im Strahlengang ermöglichen. Dieser Rückplad kann auch dazu eingesetzt werden. Testsequenzen - einmalig oder zu wiederholten Zeitpunkten - zu übertragen, die Auskunft über die einwandfreie Funktionsfähigkeit des optischen Datenübertragungssystems und des Strukturierungssystems geben.

Gemäß einer anderen Erfindungsausgestaltung kann vorteilhaft mit dem optoelektrischen Freistrahlverbindungssystem zusätzlich eine optische Energieübertragung auf das ansteuerbare Mustererzeugungssystem durchgeführt werden.

**Ausbildungsformen der Erfindung** werden zu deren weiterem Verständnis nachfolgend anhand der schematischen und teilweise zur besseren Übersicht **etwas** auseinander gezogenen Figuren näher erläutert. Dabei zeigt:
- **Figur 1**: ein vollständig in der Vakuumkammer angeordnetes Freistrahlverbindungssystem,
- **Figur** 2: ein Freistrahlverbindungssystem mit Lichtaustrittsorten linear außerhalb der Vakuumkammer,
- **Figur 3**: ein anderes Freistrahlverbindungssystem mit Lichtaustrittsorten linear außerhalb der Vakuumkammer im Ausschnitt,
- **Figur 4**: ein Freistrahlverbindungssystem mit einer Abbildungslinse im Detail,
- **Figur 5**: ein Freistrahlverbindungssystem mit Lichtaustrittsorten abgewinkelt außerhalb der Vakuumkammer,
- **Figur 6**: ein Freistrahlverbindungssystem mit Lichtaustrittsorten außerhalb, aber im Bereich der Vakuumkammer,
- **Figur 7**: einen Faserarraystecker,
- **Figur 8**: Freistrahlen mit Mikrolinsen und
- **Figur 9**: eine winklige Freistrahlführung.

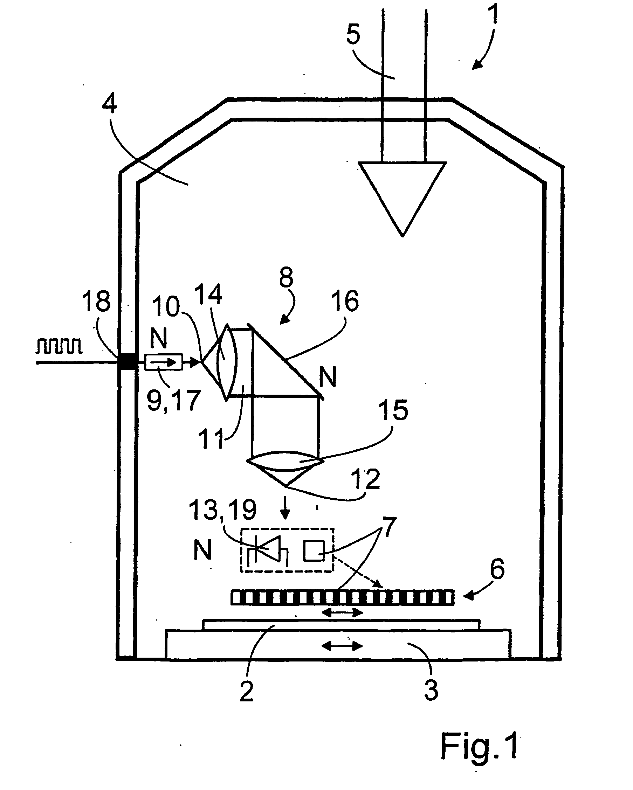

Die **Figur 1** zeigt schematisch einen Ausschnitt aus einem maskenlosen Lithographiesystem **1** nach der Erfindung zur direkten, nanoskalierbaren Strukturierung eines Substrats **2,** beispielsweise ein Wafer aus Silizium, das auf einem verfahrbaren Halterungstisch **3** angeordnet ist. Dargestellt ist im Querschnitt die Vakuumkammer **4** mit einem herrschenden Potenzial von z. B. 100 kV im Inneren. Ein homogener breiter Teilchenstrahl **5,** hier aus Elektronen, wird aus der auch im Hochvakuum befindlichen Strahlquelle von oben in die Vakuumkammer **4** geleitet und trifft dort auf ein ansteuerbares Mustererzeugungssystem **6** oberhalb des Substrats **2.** Im Mustererzeugungssystem **6,** bei dem es sich bevorzugt um ein programmierbares Aperturplattensystem handeln kann, wird computerunterstützt ein digitales Strukturierungsmuster für die Belichtung des Substrats **2** mit dem Teilchenstrahl **5** erzeugt. Dazu werden einzeln adressierbare Aperturen **7,** die die Strukturpunkte bzw. Einzelelemente darstellen, in Abhängigkeit von ihrer Position im zu erzeugenden Strukturierungsmuster und von ihrer Position über dem verschieblichen Substrat **2** angesteuert. Die zu übertragende Datenrate ist bei sehr feinen Strukturen und einer hohen Belichtungsgeschwindigkeit entsprechend hoch und kann im Tbit/s-Bereich liegen.

Die Daten für die Ansteuerung erhält das Mustererzeugungssystem **6** über ein optoelektrisches Freistrahlverbindungssystem **8.** Dieses besteht im gezeigten Ausführungsbeispiel aus elektrooptischen Wandlern **9,** Lichtaustrittsorten **10,** Freistrahlen **11,** Lichteintrittsorten **12** und optoelektrischen Wandlern **13.** Die elektrischen Musterdaten werden elektrooptisch gewandelt, mittels Freistrahlen **11** auf das Mustererzeugungssystem **8** übertragen und dort nach ihrer optoelektrischen Wandlung als Steuerdaten weiterverarbeitet. Dabei wird die Anzahl **N** der Freistrahlen **11** (und damit der elektrooptischen Wandler **9** und der optoelektrischen Wandler **13)** über die vorgegebene Wandlungsrate der elektrooptischen Wandler **9** an die zu übertragende Summendatenrate angepasst. Dabei sei an dieser Stelle angemerkt, dass die einzeln gezeigten Bauelemente jeweils auch immer als Array angeordnet sein können. Für die Übertragung einer Datenrate von 2,56 Tbit/s sind beispielsweise **N** = 256 parallele Freistrahlen **11** mit einer von elektrooptischen Wandlern **9** jeweilig erzeugbaren Datenrate von 10 Gbit/s erforderlich.

Im gezeigten Ausführungsbeispiel befinden sich sowohl die Lichtaustrittsorte **10** als auch die Lichteintrittsorte **12** (jeweils schematisch dargestellt) innerhalb der Vakuumkammer **4.** Damit kann eine sehr kurze Freistrahlstrecke realisiert werden, die insbesondere der mechanischen Entlastung des Mustererzeugungssystems **8** durch entfallende Kontaktierungen dient. In diesem Falle können die Freistrahlen **11** von kollimierenden Mikrolinsen **14** und fokussierenden Mikrolinsen **15** gebündelt werden. Zur Umlenkung werden die Freistrahlen **11** im gewählten Ausführungsbeispiel über Umlenkvorrichtungen **16,** beispielsweise Mikrospiegel, um 90° umgelenkt. Dabei werden die Umlenkvorrichtungen **16** aber grundsätzlich so angeordnet, dass sie den Teilchenstrahl **5** nicht behindern. Im gezeigten Ausführungsbeispiel werden die Lichtaustrittsorte **10** direkt von aktiven Sendelasern **17** als elektrooptische Wandler **9** gebildet. Die somit als elektrische Signale vorliegenden Musterdaten werden leitungsgebunden mittels Drähten, die durch Durchführungen **18** in der Wandung der Vakuumkammer **4** geführt werden, zugeführt. Befinden sich die elektrooptischen Wandler **9** außerhalb der Vakuumkammer **4,** so kann eine Zuführung der optisch gewandelten Daten in das Innere der Vakuumkammer beispielsweise auch über Lichtwellenleiter erfolgen. Die Lichtaustrittsorte **10** liegt dann an den Enden der Lichtwellenleiter. Die Lichteintrittsorte **12** werden im gezeigten Beispiel direkt von Empfangselementen, z. B. Photodioden, **19** als optoelektrische Wandler **13** gebildet. Bedarfsweise können bei einer solchen Realisierung mit einer sehr kurzen Freistrahlstrecke auch die Mikrolinsen **14, 15** entfallen.

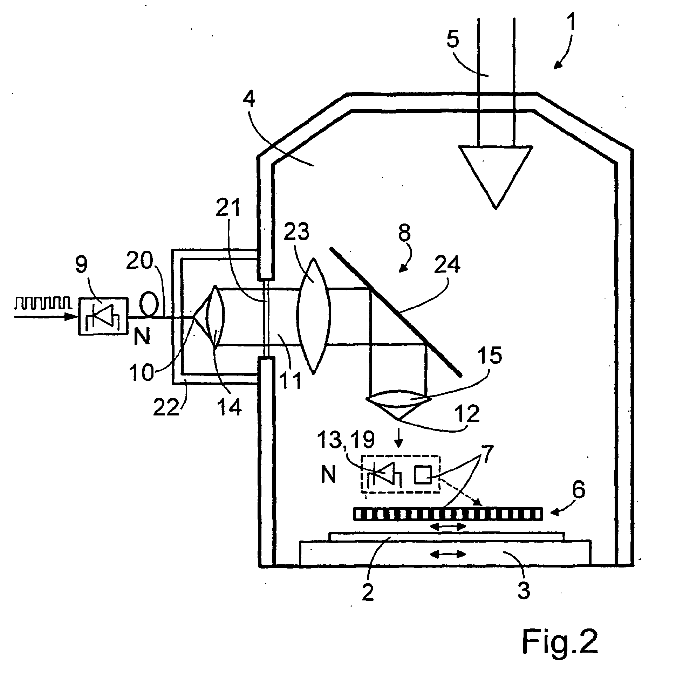

In der **Figur 2** ist eine Ausführungsform der Erfindung mit einer langen Freistrahlstrecke gezeigt, bei der sich die Lichtaustrittsorte **10** des Freistrahlverbindungssystem **8** außerhalb der Vakuumkammer **4** befinden und von den Enden von passiven Lichtwellenleitern **20** gebildet werden, an deren Anfang die elektrooptischen Wandler **9** positioniert sind (aktive Sendeelemente sind hier ebenfalls möglich). Auch bei dieser Ausbildung können vorkollimierende Mikrolinsen **14** am Ende der Lichtwellenleiter **20** vorgesehen sein. Gezeigt sind auch fokussierende Mikrolinsen **15,** die jedoch auch entfallen können. Die Freistrahlen **11** werden über ein Fenster **21,** hierbei kann es sich um eine einfache Glasscheibe handeln, in der Wandung der Vakuumkammer **4** in das Innere geleitet. Gegen Störeinflüsse ist das Fenster **21** mit einer Abdeckung **22** versehen. Aufgrund des großen Abstandes zwischen den Lichtaustrittsorten **10** und den Lichteintrittsorten **12** wird eine Abbildungslinse **23** verwendet, die die entsprechend positionierte Orte aufeinander abbildet. Insbesondere kompakte Array-Anordnungen der Lichtaustrittsorte **10** und der Lichteintrittsorte **12,** auch in Verbindung mit leicht lösbaren Faserarraysteckern, lassen sich mit einer Abbildungsoptik **23,** hier in Form einer einfachen Abbildungslinse, gut abbilden. Auch bei Verwendung der Abbildungsoptik **23,** deren Anordnung den Teilchenstrahl **5** nicht stören darf, können die Freistrahlen **10** mit einer den Teilchenstrahl **5** ebenfalls nicht störenden optischen Umlenkvorrichtung **24** winklig geführt werden, wobei diese alle dicht beieinander positionierten Freistrahlen **10** gemeinsam erfasst.

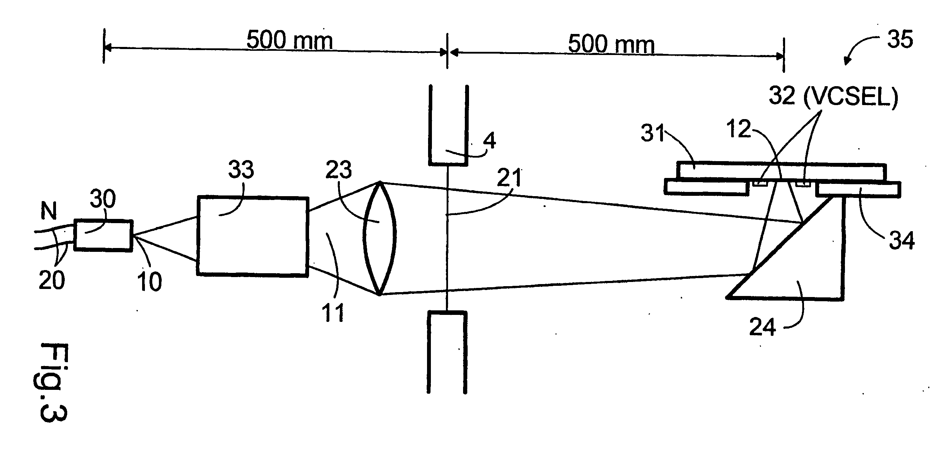

Der **Figur 3** zeigt eine bemaßte, durchgängig lineare Ausführungsanordnung mit außerhalb der Vakuumkammer **4** (nur angedeutet) angeordneten Lichtaustrittsorten **10.** Diese werden von einem Faserarraystecker **30** gebildet. Im gewählten Ausführungsbeispiel weist der Faserarraystecker **30** (6x12) Lichtwellenleiter **20** in Form von Glasfasern und zwei Photodioden (Vier-Quadranten) zum Empfang von Rücksignalen auf. Über die Abbildungslinse **23** werden die gebündelten Freistrahlen **11** durch das Fenster **21** über eine optische Umlenkvorrichtung **24** auf ein Photodiodenarray **31** geleitet. Dieses weist im gewählten Ausführungsbeispiel neben (6x12) Photodioden auch zwei Sendelaser **32** (VCSEL) zur Erzeugung von Rücksignalen auf. Diese werden auf die beiden Photodioden mit Vierquadrantenaufbau im Faserarraystecker 30 rückgeleitet und dienen der Überprüfung der Ausrichtung der Freistrahlen 11 auf das Photodiodenarray **31.** Auftretende Abweichung werden in einem automatisierbaren Justagesystem **33,** das in der Freistrahlstrecke angeordnet ist, optisch ausgeregelt. Eine mechanische, Justage durch beispielsweise eine Verschiebung des Faserarraysteckers **30** ist möglich. Das auf einer Trägerplatte **34** mit quadratischen Öffnungen angeordnete Photodiodenarray **31** ist im gewählten Ausführungsbeispiel mit einem Elektronikchip kombiniert ausgeführt und enthält auch die erste Stufe des Demultiplexers zur Verteilung der empfangenen, optoelektrisch gewandelten Musterdaten. Nicht dargestellt ist ein weitere Elektronikchip mit den entsprechende Aperturen. Das gesamte System wird als programmierbares Aperturplattensystem **35** bezeichnet.

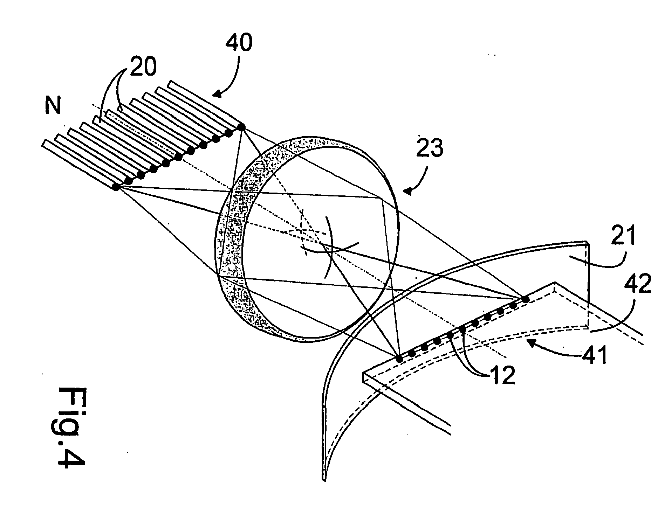

Der **Figur 4** sind Details zur Abbildungslinse **23** zu entnehmen. Mehrere Lichtwellenleiter **20** sind hier zu einem zeilenförmigen Faserarray **40** zusammengefasst. Eine Zusammenfassung in Zeilen und Spalten in einem Faserarraystecker (s.o.) zur Erzielung noch kompakterer Abmessungen und einfacherer Montage ist auch möglich. Das zeilenförmige Faserarray **40** wird über die Abbildungslinse **23** durch das Fenster **21** hindurch auf einem zeilenförmigen Lichteintrittsarray **41** spiegelverkehrt (in der **Figur 3** angedeutet durch Strahllinien) abgebildet. Gezeigt ist eine ungefähre 1:1-Abbildungsoptik **23** mit einer einfachen Abbildungslinse , die einen großen Arbeitsabstand in der Freistrahlstrecke ermöglicht. Bei einer unsymmetrischen Anordnung der Abbildungsoptik **23** können andere Abbildungsverhältnisse gewählt werden. Im gewählten Ausführungsbeispiel werden die Lichteintrittsorte **12** von Photodioden gebildet, die monolithisch in einem Halbleiterchip **42,** z. B. aus Silizium für eine Übertragungswellenlänge von 850 nm, integriert sind.

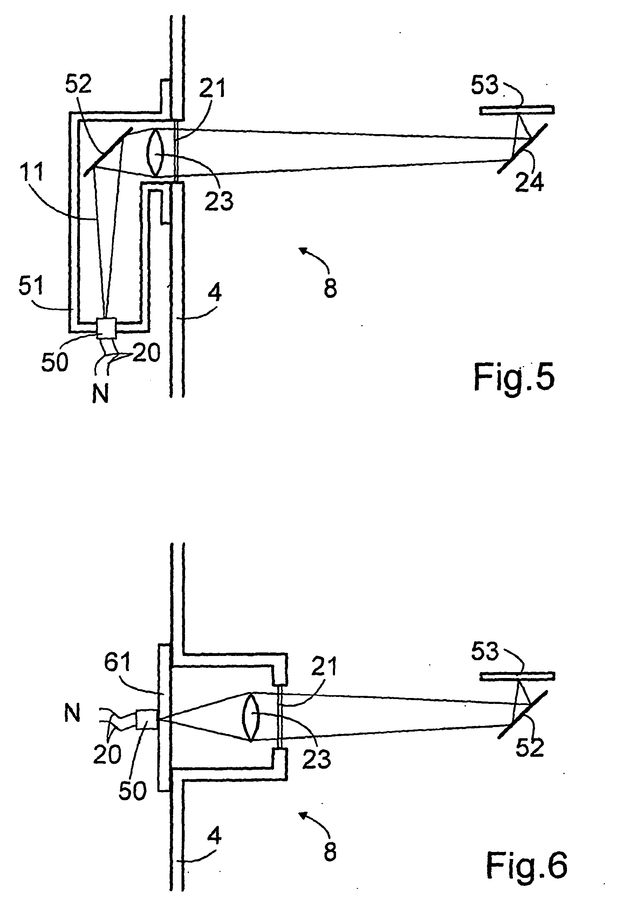

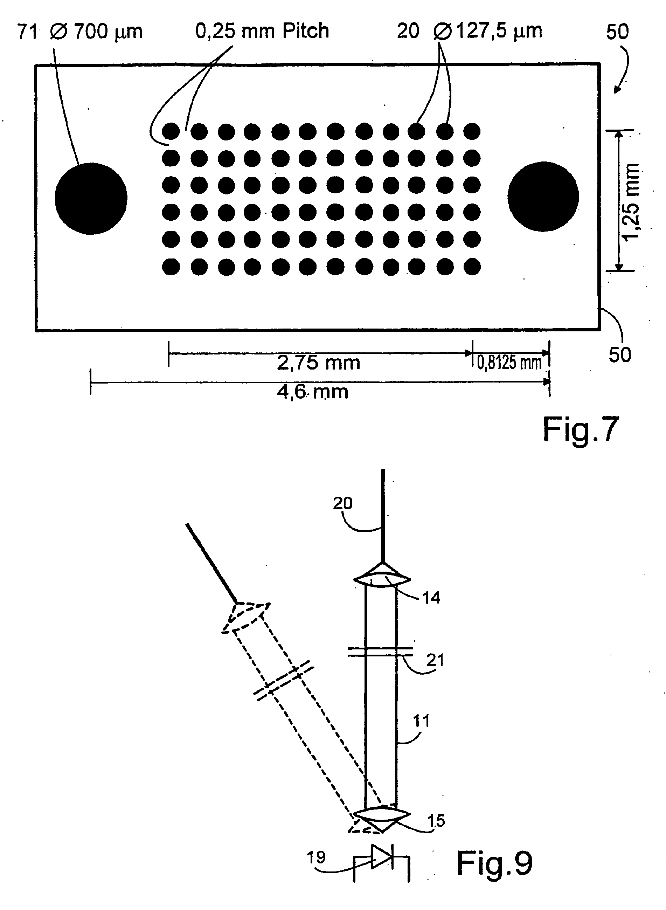

In der **Figur 5** ist ein Ausführungsbeispiel mit einer Anordnung eines Faserarraysteckers **50,** in dem die Enden einer Anzahl von N Lichtwellenleitern **20** zusammengefasst sind, und einer Abbildungslinse **23** außerhalb der Vakuumkammer **4** dargestellt. Die Umlenkung des Bündels aus Freistrahlen **11** erfolgt über die zusätzliche optische Umlenkvorrichtung **52** in der Höhe des Fensters **21.** Sowohl der Faserarraystecker **50** als auch die optische Umlenkvorrichtung **24** sind einer winkligen Abdeckung **51** integriert, die gleichzeitig der mechanischen Befestigung und der Abschirmung von optischen Störeinflüssen sowie dem Schutz der Abbildungslinse **23** dient. Eine weitere optische Umlenkvorrichtung **24** ist im Innern der Vakuumkammer **4** angeordnet, die das Bündel aus Freistrahlen **11** im gewählten Ausführungsbeispiel auf ein Photodiodenarray **53** lenkt. In der **Figur 6** ist eine ähnliche Ausführungsform zu **Figur 5** dargestellt, wobei das Fenster **21** nunmehr in die Vakuumkammer **4** hineingezogen ist. Der Faserarraystecker **50** ist auf einer Platte **61** montiert, die gleichzeitig der Abschirmung von optischen Störeinflüssen dient. Die Abbildungsoptik **23** ist wiederum genau vor dem Fenster **21** angeordnet. Durch diese Anordnung sind kleinere Abmessungen des Freistrahlverbindungssystems **8** und damit kompaktere Konstruktionsmaße erreichbar. In der **Figur 7** ist in der Frontalansicht der bemaßte Faserarraystecker **50** mit zwei Befestigungslöchern **71** dargestellt, der im gewählten Ausführungsbeispiel sechs Zeilen mit je zwölf Lichtwellenleitern **20** enthält, die vertikal und horizontal einen vorgegeben, hier gleichen Pitchabstand aufweisen.

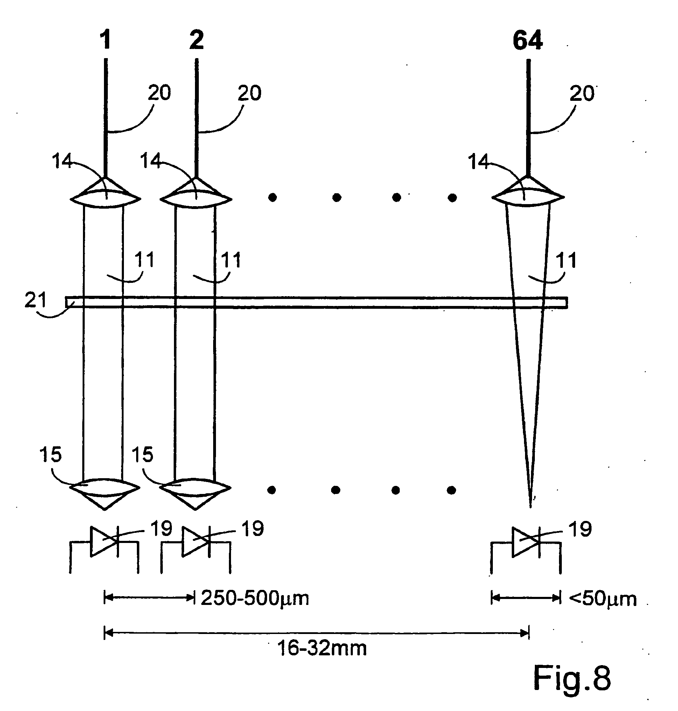

In der **Figur 8** sind mögliche, bemaßte Anordnungen von kollimierenden Mikrolinsen **14** und fokussierenden Mikrolinsen **15** in den Freistrahlen **11** beiderseits des Fensters **21** dargestellt. Dabei können die fokussierenden Mikrolinsen **15** vor den Photodioden **19** optional entfallen (in der Figur 8 nur rechts angedeutet). Gezeigt sind 1...64 Lichtwellenleiter **20** gemäß dem gewählten Ausführungsbeispiel. In der **Figur 9** ist die mögliche winklige Einstrahlung in die Photodiode **19** dargestellt. Diese wird durch eine entsprechende Drehung (gestrichelt angedeutet) der fokussierenden Mikrolinse **15** und des Fensters **21** realisiert und ermöglicht die Anpassung der Ausrichtung der Freistrahlen **11** an die räumlichen Gegebenheiten in der Vakuumkammer **4.**

### Bezugszeichenliste

- 1: Lithographiesystem
- 2: Substrat
- 3: Halterungstisch
- 4: Vakuumkammer
- 5: Teilchenstrahl
- 6: Mustererzeugungssystem
- 7: Apertur
- 8: Freistrahlverbindungssystem
- 9: elektrooptischer Wandler
- 10: Lichtaustrittsort
- 11: Freistrahl
- 12: Lichteintrittsort
- 13: optoelektrischer Wandler
- 14: kollimierende Mikrolinse
- 15: fokussierende Mikrolinse
- 16: optische Umlenkvorrichtung
- 17: Sendelaser
- 18: Durchführung
- 19: Photodiode
- 20: Lichtwellenleiter (Anzahl N)
- 21: Fenster
- 22: Abdeckung
- 23: Abbildungsoptik
- 24: optische Umlenkvorrichtung
- 30: Faserarraystecker
- 31: Photodiodenarray
- 32: Sendelaser
- 33: Justagesystem
- 34: Trägerplatte
- 35: Aperturplattensystem
- 40: Faserarray
- 41: Lichteintrittsarray
- 42: Halbleiterchip
- 50: Faserarraystecker
- 51: Abdeckung
- 52: zusätzliche optische Umlenkvorrichtung
- 53: Photodiodenarray
- 61: Platte
- 71: Befestigungsloch

## Patentansprüche

1. Maskenloses Lithographiesystem zur direkten, nanoskalierbaren Strukturierung eines Substrats (2) in einer Vakuumkammer mittels eines von einer Strahlenquelle erzeugten, geladenen Teilchenstrahls und einer in der Vakuumkammer herrschenden Hochspannung, umfassend:
die Vakuumkammer;
einen verfahrbaren Halterungstisch zum Anordnen des Substrats auf demselben;
ein ansteuerbares digitales Mustererzeugungssystem, welches als programmierbares Aperturplattensystem (35) mit einer Aperturplatte ausgebildet ist,
ein Datenübertragungssystem zum übertragen eines zu erzeugenden Strukturmusters als computergestützt erzeugter Musterdatensatz auf das Mustererzeugungssystem, wobei das Datenübertragungssystem elektrooptische Wandler (9) und optoelektrische Wandler (13) umfasst, und
wobei das Datenübertragungssystem als optoelektrisches Freistrahlverbindungssystem (8) dazu ausgebildet ist, die von den elektrooptischen Wandlern (9) optisch gewandelten Musterdaten auf Lichtaustrittsorte (10) zu verteilen, sie von dort in justierbar ausgerichteten Freistrahlen (11) auf Lichteintrittsorte (12) im Innern der Vakuumkammer (4) zu übertragen,
welche in einem Array angeordnet sind, und von dort den optoelektrischen Wandlern (13) zuzuleiten, welche dem Mustererzeugungssystem (6) bezüglich der übertragenen Musterdaten zugeordnet sind,
**dadurch gekennzeichnet, dass** die optoelektrischen Wandler (13) auf der Aperturplatte des Aperturplattensystems angeordnet sind,
wobei die Anzahl N der elektrooptischen Wandler (9) aufgrund ihrer vorgegebenen Wandlungsrate an die zu übertragende Musterdatenrate angepasst ist,
wobei ein automatisierbares Justagesystem (33) zur Ausrichtung der Freistrahlen (11) auf die Lichteintrittsorte (12) vorgesehen ist
wobei im Bereich des Mustererzeugungssystems (6) zusätzliche elektroopische Wandler angeordnet sind, mittels denen weitere optische Signale, insbesondere Kontroll- und Steuersignale, erzeugt und in Rückrichtung über Freistrahlen (11) auf zusätzliche optoelektrische Wandler geleitet werden, wobei die weiteren optischen Signale als Rücksignale für das automatisierbare Justagesystem (33) einsetzbar sind.

2. Maskenloses Lithographiesystem nach Anspruch 1, wobei im Innern der Vakuumkammer (4) optische Umlenkvorrichtungen (16; 24) in den Freistrahlen (11) angeordnet sind.

3. Maskenloses Lithographiesystem nach Anspruch 1 oder Anspruch 2, wobei die Lichtaustrittsorte (10) außerhalb der Vakuumkammer (4) angeordnet sind und die Freistrahlen (11) durch ein lichtdurchlässiges Fenster (21) in der Vakuumkammer (4) in das Innere der Vakuumkammer (4) geleitet werden.

4. Maskenloses Lithographiesystem nach Anspruch 3, wobei die Lichtaustrittsorte (10) direkt von außen am Fenster (21) angeordnet sind.

5. Maskenloses Lithographiesystem nach Anspruch 3, wobei die Lichtaustrittsorte (10) rechtwinklig unterhalb des Fensters (21) angeordnet sind und die Freistrahlen (11) über eine zusätzliche optische Umlenkvorrichtung (16) über das Fenster (21) in das Innere der Vakuumkammer (4) geleitet werden.

6. Maskenloses Lithographiesystem nach einem der Ansprüche 3 bis 5, wobei das Fenster (13) in die Vakuumkammer (4) hineingezogen ist.

7. Maskenloses Lithographiesystem nach einem der Ansprüche 3 bis 6, wobei das Fenster (21) außerhalb der hindurchtretenden Freistrahlen (11) mit einer Abdeckung (22;51;61) gegen Fremdlicht und elektromagnetische Felder abgeschirmt ist.

8. Maskenloses Lithographiesystem nach einem der Ansprüche 1 bis 7, wobei kollimierende und fokussierende Mikrolinsen (14,15) an den Lichtaus- und/oder -eintrittsorten (10,12) angeordnet sind.

9. Maskenloses Lithographiesystem nach einem der Ansprüche 1 bis 8, wobei die Lichteintrittsorte und/oder Lichtaustrittsorte (10,12) in einem Array (40) angeordnet sind.

10. Maskenloses Lithographiesystem nach Anspruch 9, wobei das Array (40) der Lichtaustrittsorte (10) über eine Abbildungsoptik (23) auf das Array (41) der Lichteintrittsorte (12) abgebildet wird.

11. Maskenloses Lithographiesystem nach einem der Ansprüche 1 bis 10, wobei die Lichteintrittsorte (12) und/oder Lichtaustrittsorte (10) von den Enden von Lichtwellenleitern (20) gebildet werden.

12. Maskenloses Lithographiesystem nach Anspruch 9 und 11, wobei die Enden der Lichtwellenleiter (20) bei deren Ausbildung als Lichtfasern in einem Faserarraystecker (30) zusammengefaßt sind.

13. Maskenloses Lithographiesystem nach einem der Ansprüche 1 bis 10, wobei die elektrooptischen Wandler (10) als Leicht-austrittsorte (10) in Form von aktiven Sendeelementen, insbesondere Sendelasern (32), ausgebildet sind.

14. Maskenloses Lithographiesystem nach einem der Ansprüche 1 bis 10, wobei die optoelektrischen Wandler (13) als Lichteintrittsorte (12) in Form von aktiven Empfangselementen, insbesondere Photodioden (19), ausgebildet sind.

15. Maskenloses Lithographiesystem nach Anspruch 14, wobei das Justagesystem (33) im Strahlengang des Freistrahlverbindungssystems (8) angeordnet ist.

16. Maskenloses Lithographiesystem nach einem der Ansprüche 1 bis 15, wobei mit dem optoelektrischen Freistahlverbindungssystem (8) zusätzlich eine optische Energieübertragung auf das ansteuerbare Mustererzeugungssystem (6) durchgeführt wird.

## Claims

1. Maskless lithography system for direct, nano-scaleable structuring of a substrate (2) in a vacuum chamber by means of a charged particle beam generated by a radiation source and by means of high voltage present within the vacuum chamber, comprising:
the vacuum chamber;
a movable mounting table for disposing the substrate on same;
a controllable digital pattern generating system formed as a programmable aperture plate system (35) with an aperture plate, and
a data transmission system for transmitting a structure pattern to be formed as a set of pattern data, generated with computer assistance, to the pattern generating system, said data transmission system comprising electro-optical converters (9) and opto-electrical converters (13), and
wherein said data transmission system is configured as an opto-electrical free beam connection system (8) to distribute the pattern data optically converted by the electro-optical converters (9) onto light exit locations (10), to transmit said pattern data from there in adjustably oriented free beams (11) onto light entry locations (12) arranged in an array inside the vacuum chamber (4), and to guide said pattern data from there to the opto-electrical converters (13) associated with the pattern generating system (6) with respect to the transmitted pattern data,
**characterized in that** the opto-electrical converters (13) are arranged on the aperture plate of the aperture plate system,
the number N of the electro-optical converters (9) being adapted to the rate of pattern data to be transmitted, based on the predetermined transmission rate of the electro-optical converters (9),
wherein an adjustment system (33) suitable for being automated is provided for aligning the free beams (11) with the light entry locations (12),
wherein additional electro-optical converters are disposed, in the region of the pattern generating system (6), said converters serving to generate additional optical signals, in particular monitoring and control signals, and to guide said additional optical signals in a back direction via free beams (11) onto additional opto-electrical converters, wherein said additional optical signals are suitable for being used as back signals for the adjustment system (33) which is suitable for automation.

2. Maskless lithography system according to claim 1, wherein optical deflection arrangements (16; 24) are disposed in the free beams (11) inside the vacuum chamber (4).

3. Maskless lithography system according to claim 1 or claim 2, wherein the light exit locations (10) are disposed outside the vacuum chamber (4) and the free beams (11) are guided into the interior of the vacuum chamber (4) through a transparent window (21) in the vacuum chamber (4).

4. Maskless lithography system according to claim 3, wherein the light exit locations (10) are disposed directly at the window (21) from the outside.

5. Maskless lithography system according to claim 3, wherein the light exit locations (10) are disposed orthogonally beneath the window (21), and wherein the free beams (11) are guided by an additional optical deflection arrangement (16) through the window (21) into the vacuum chamber (4).

6. Maskless lithography system according to one of claims 3 to 5, wherein the window (13) is drawn-in into the vacuum chamber (4).

7. Maskless lithography system according to one of claims 3 to 6, wherein the window (21) is shielded by a cover (22; 51; 61) against external light and electromagnetic fields outside of the region where the free beams (11) pass through.

8. Maskless lithography system according to one of claims1 to 7, wherein collimating and focussing microlenses (14, 15) are disposed at the light exit locations and/or light entry locations (10, 12).

9. Maskless lithography system according to one of claims 1 to 8, wherein the light entry locations and/or light exit locations (10, 12) are arranged in an array (40).

10. Maskless lithography system according to claim 9, wherein the array (40) of the light exit locations (10) is imaged by imaging optics (23) onto the array (41) of light entry locations (12).

11. Maskless lithography system according to one of claims 1 to 10, wherein the light entry locations (12) and/or the light exit locations (10) are formed by the ends of light waveguides (20).

12. Maskless lithography system according to claims 9 and 11, wherein the ends of the light waveguides (20), which are formed as light fibres, are combined into a fibre array plug (30).

13. Maskless lithography system according to one of claims 1 to 10, wherein the electro-optical converters (10) are formed as light exit locations (10) in the form of active emitting elements, in particular emitting lasers (32).

14. Maskless lithography system according to one of claims 1 to 10, wherein the opto-electrical converters (13) are formed as light entry locations (12) in the form of active receiving elements, in particular photodiodes (19).

15. Maskless lithography system according to claim 14, wherein the adjustment system (33) is disposed in the beam path of the free beam connection system (8).

16. Maskless lithography system according to one of claims 1 to 15, wherein a transfer of optical energy to the addressable pattern generating system (6) is additionally carried out by the opto-electrical free beam connection system (8).

## Revendications

1. Système lithographique sans masque pour la structuration directe à nanomodularité d'un support (2) dans une chambre à vide au moyen d'un jet de particules chargé, comprenant :
la chambre à vide ;
une table de fixation déplaçable pour disposer le support sur celle-ci ;
un système numérique de production de modèles pouvant être commandé, lequel est conçu comme système programmable de plaques d'ouverture (35) avec une plaque d'ouverture, et
un système de transmission de données pour transmettre un modèle de structure à produire comme jeu de données de modèle produit de manière assistée par ordinateur vers le système de production de modèle, le système de transmission de données comprenant un convertisseur électro-optique (9) et un convertisseur optoélectrique (13), et
le système de transmission de données étant conçu comme système optoélectrique de combinaison à jet libre (8), pour répartir les jeux de données convertis de manière optique par les convertisseurs optoélectriques (9) à des points de sortie de lumière (10), les transmettre de là en des jets libres (11) orientés ajustables sur des points d'entrée de lumière (12) situés à l'intérieur de la chambre à vide (4), lesquels sont disposés dans un tableau, et de là les conduire aux convertisseurs optoélectriques (13), lesquels sont affectés au système de production de modèle (6) en fonction des données de modèles transmis,
**caractérisé en ce que** les convertisseurs optoélectriques (13) sont disposés sur la plaque d'ouverture du système de plaques d'ouverture,
le nombre N de convertisseurs électro-optiques (9) étant adapté en fonction du taux de conversion prescrit au taux de données de modèle à transmettre,
**caractérisé en ce qu'**un système d'ajustage automatisable (33) est prévu pour l'ajustage des jets libres (11) sur les points d'entrée de lumière (12),
**caractérisé en ce que** dans la zone du système de production de modèles (6) sont disposés des convertisseurs électro-optiques supplémentaires, au moyen desquels sont produits d'autres signaux optiques, en particulier des signaux de contrôle et de commande et guidés en direction de retour par l'intermédiaire de jets libres (11) sur des convertisseurs optoélectriques supplémentaires, les autres signaux optiques pouvant être utilisables comme signaux de retour pour le système d'ajustage automatisable (33).

2. Système lithographique sans masque selon la revendication 1, **caractérisé en ce qu'**à l'intérieur de la chambre à vide (4) sont disposés des dispositifs optiques de déviation (16; 24) dans les jets libres (11).

3. Système lithographique sans masque selon la revendication 1 ou la revendication 2, **caractérisé en ce que** les points de sortie de lumière (10) sont disposés à l'extérieur de la chambre à vide (4) et les jets libres (11) sont guidés à l'intérieur de la chambre à vide (4) par une fenêtre laissant passer la lumière (21) située dans la chambre à vide (4).

4. Système lithographique sans masque selon la revendication 3, **caractérisé en ce que** les points de sortie de lumière (10) sont disposés directement à l'extérieur sur la fenêtre (21).

5. Système lithographique sans masque selon la revendication 3, **caractérisé en ce que** les points de sortie de lumière (10) sont disposés en angle droit sous la fenêtre (21) et les jets libres (11) sont guidés par l'intermédiaire d'un dispositif de déviation optique supplémentaire (16) au dessus de la fenêtre (21) vers l'intérieur de la chambre à vide (4).

6. Système lithographique sans masque selon l'une des revendications 3 à 5, **caractérisé en ce que** la fenêtre (13) s'étire dans la chambre à vide (4).

7. Système lithographique sans masque selon l'une des revendications 3 à 6, **caractérisé en ce que** la fenêtre (21) est protégée, à l'extérieur des jets libres (11) la transperçant, par un capot (22 ; 51 ; 61) contre la lumière parasite et des champs électromagnétiques.

8. Système lithographique sans masque selon l'une des revendications 1 à 7, **caractérisé en ce que** des microlentilles (14, 15) à focalisation et à collimation sont disposées aux points de sortie et/ou d'entrée de la lumière (10, 12).

9. Système lithographique sans masque selon l'une des revendications 1 à 8, **caractérisé en ce que** les points d'entrée de lumière et/ou les points de sortie de lumière (10, 12) sont disposés dans un tableau (40).

10. Système lithographique sans masque selon la revendication 9, **caractérisé en ce que** le tableau (40) des points de sortie de lumière (10) est représenté par un système optique de représentation (23) sur le tableau (41) des points d'entrée de lumière (12).

11. Système lithographique sans masque selon l'une des revendications 1 à 10, **caractérisé en ce que** les points d'entrée (12) et/ou de sortie de lumière (10) sont formés par les extrémités des guides d'ondes optiques (20).

12. Système lithographique sans masque selon les revendications 9 et 11, **caractérisé en ce que** les extrémités des guides d'ondes optiques (20) sont regroupées dans leur conception comme fibres optiques dans une prise de tableau de fibres (30).

13. Système lithographique sans masque selon l'une des revendications 1 à 10, **caractérisé en ce que** les convertisseurs électro-optiques (13) sont conçus comme des points de sortie de lumière (10) sous forme d'éléments émetteurs actifs, en particulier des lasers émetteurs (32).

14. Système lithographique sans masque selon l'une des revendications 1 à 10, **caractérisé en ce que** les convertisseurs optoélectriques (13) sont conçus comme des points d'entrée de lumière (12) sous forme d'éléments récepteurs actifs, en particulier des photodiodes (19).

15. Système lithographique sans masque selon la revendication 14, **caractérisé en ce que** le système d'ajustage (33) est disposé dans la voie de jet du système de combinaison à jet libre (8).

16. Système lithographique sans masque selon l'une des revendications 1 à 15, **caractérisé en ce qu'**avec le système optoélectrique de combinaison à jet libre (8) est réalisée en outre une transmission optique d'énergie vers le système de production de modèles (6).
